# EUROPEAN PATENT APPLICATION

(11) **EP 4 844 532 A1**
(43) Date of publication of application: **25.11.2026**
(21) Application number: 26179526.4
(22) Date of filing: 19.05.2026
(51) Int. Cl.: G06F 1/20, H10W 40/22, H10W 40/47, H10W 40/73

(54) **LIQUID COOLING HEAT DISSIPATION DEIVCE**

(30) Priority: 23.05.2025 TW 114205252 U
(71) Applicant: Cooler Master Co., Ltd., Taipei City 114065 (TW)
(72) Inventor: SHIH, Hong-Yi, 114065 Taipei City (TW); CHEN, Wen-ching, 114065 Taipei City (TW); HUNG, Liang, 114065 Taipei City (TW)
(74) Representative: Grünecker Patent- und Rechtsanwälte PartG mbB

(57) **Abstract**

A liquid cooling heat dissipation device can include a base, a cover, a plurality of fins, and a flow channel plate. The base can define a chamber and can include at least one first flow channel opening and at least one second flow channel opening fluidly connected to the chamber. The cover can be coupled to the base and can partly enclose the chamber. The cover can include a first side surface configured to be thermally coupled to a heat source and a second side surface facing the chamber. The fins can extend from the second side surface of the cover into the chamber. Each fin can include first capillary structures disposed on opposite side surfaces. The flow channel plate can be coupled to a side of the base opposite to the cover and can include groove channels fluidly connected to the chamber through the flow channel openings.

## Description

### TECHNICAL FIELD

The present disclosure relates to heat dissipation devices, and more particularly to a liquid cooling heat dissipation device having capillary structures.

### BACKGROUND

Electronic devices generate heat during operation. If the heat is not effectively dissipated, electronic components in the electronic devices may overheat, which may adversely affect operation, reliability, and service life of the electronic devices. To address such issues, heat dissipation devices are often used to transfer heat away from heat-generating components and maintain the heat-generating components within desired operating temperature ranges. As power density and heat flux of electronic components increase, conventional air-cooling solutions may be insufficient for certain applications, and liquid cooling solutions have been used to improve heat transfer performance.

However, as electronic devices continue to become smaller and thinner, available space for heat dissipation devices is increasingly limited. In addition, in liquid cooling devices using two-phase flow cooling, liquid-phase cooling fluid and vapor generated during heat absorption may not be effectively separated. Such insufficient gas-liquid separation may increase thermal resistance and reduce heat dissipation efficiency and reliability. Accordingly, improvements to liquid cooling heat dissipation devices are desirable.

### SUMMARY

The invention is as defined in the appended claims. Aspects of the present disclosure provide a liquid cooling heat dissipation device. The liquid cooling heat dissipation device can include a base, a cover, a plurality of fins, and a flow channel plate. The base can define a chamber and can include at least one first flow channel opening and at least one second flow channel opening fluidly connected to the chamber. The cover can be coupled to the base and can enclose the chamber at least in part. The cover can include a first side surface and a second side surface opposite to the first side surface. The first side surface can be configured to be thermally coupled to a heat source, and the second side surface can face the chamber. The fins can extend from the second side surface of the cover into the chamber. Each of the fins can include opposite side surfaces and a plurality of first capillary structures disposed on the opposite side surfaces. The flow channel plate can be coupled to a side of the base opposite to the cover. The flow channel plate can include a first flow channel connector opening, a second flow channel connector opening, at least one first groove channel fluidly connected to the chamber through the at least one first flow channel opening, and at least one second groove channel fluidly connected to the chamber through the at least one second flow channel opening.

In some embodiments, the at least one first flow channel opening can include two first flow channel openings disposed at two opposite sides of the base, and the at least one second flow channel opening can be disposed between the two first flow channel openings. In certain embodiments, the two first flow channel openings can be elongated openings, and the at least one second flow channel opening can be a circular opening.

In some implementations, the flow channel plate can include a first side facing away from the chamber and a second side facing the chamber. The first flow channel connector opening and the second flow channel connector opening can be disposed at the first side, and the at least one first groove channel and the at least one second groove channel can be disposed at the second side.

In certain implementations, the first capillary structures can include microporous structures configured to generate capillary force. In some examples, the first capillary structures can include three-dimensional printed sintered structures, powder sintered structures, ceramic sintered structures, or combinations thereof. Optionally, the powder sintered structures can be formed of metal powder including iron powder, stainless steel powder, bronze powder, brass powder, or combinations thereof.

In some embodiments, a height of the first capillary structures can be equal to a height of the fins. In such embodiments, the chamber can include a chamber bottom surface facing the second side surface of the cover, and at least one recessed structure can be formed in a portion of the chamber bottom surface corresponding to at least one of the fins. In certain examples, the at least one of the fins corresponding to the at least one recessed structure can be spaced apart from the chamber bottom surface. Additionally or alternatively, at least one of the first capillary structures disposed on the at least one of the fins corresponding to the at least one recessed structure can be spaced apart from the chamber bottom surface.

In other embodiments, the chamber can include a chamber bottom surface facing the second side surface of the cover, and a height of the first capillary structures can be less than a height of the fins such that each of the first capillary structures is spaced apart from the chamber bottom surface. In some implementations, each of the first capillary structures can include a first end and a second end opposite to the first end. The first end can be flush with an end of a corresponding fin that contacts the second side surface, and the second end can be spaced apart from the chamber bottom surface. In certain examples, each of the fins can include an exposed section between the second end of a corresponding first capillary structure and the chamber bottom surface.

In some embodiments, the liquid cooling heat dissipation device can further include a plurality of second capillary structures disposed on the second side surface of the cover. In some implementations, the second capillary structures can extend along the second side surface of the cover and can be perpendicular to the first capillary structures. In certain examples, the second capillary structures can comprise three-dimensional printed sintered structures, powder sintered structures, ceramic sintered structures, or combinations thereof.

In other embodiments, the liquid cooling heat dissipation device can further include a plurality of second capillary structures disposed on the second side surface of the cover. The chamber can include a chamber bottom surface facing the second side surface of the cover, and ends of the fins away from the second side surface can directly abut against the chamber bottom surface. In some implementations, ends of the first capillary structures away from the second side surface can directly abut against the chamber bottom surface. In certain examples, the first capillary structures can comprise three-dimensional printed sintered structures, powder sintered structures, ceramic sintered structures, or combinations thereof, and the second capillary structures can be copper-mesh sintered structures.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
FIG. 1 illustrates a perspective view of a liquid cooling heat dissipation device according to aspects of the present disclosure.
FIG. 2 illustrates an exploded view of the liquid cooling heat dissipation device of FIG. 1.
FIG. 3 illustrates a cross-sectional view of the liquid cooling heat dissipation device of FIG. 1 taken along line 3-3.
FIG. 4 illustrates a perspective view of a liquid cooling heat dissipation device according to aspects of the present disclosure.
FIG. 5 illustrates an exploded view of the liquid cooling heat dissipation device of FIG. 4.
FIG. 6 illustrates a cross-sectional view of the liquid cooling heat dissipation device of FIG. 4 taken along line 6-6.
FIG. 7 illustrates a perspective view of a liquid cooling heat dissipation device according to aspects of the present disclosure.
FIG. 8 illustrates an exploded view of the liquid cooling heat dissipation device of FIG. 7.
FIG. 9 illustrates a cross-sectional view of the liquid cooling heat dissipation device of FIG. 7 taken along line 9-9.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

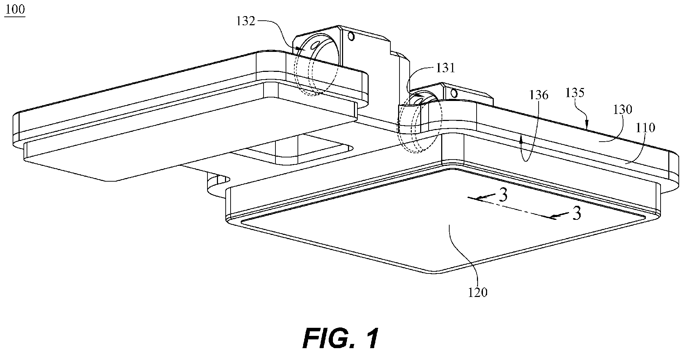

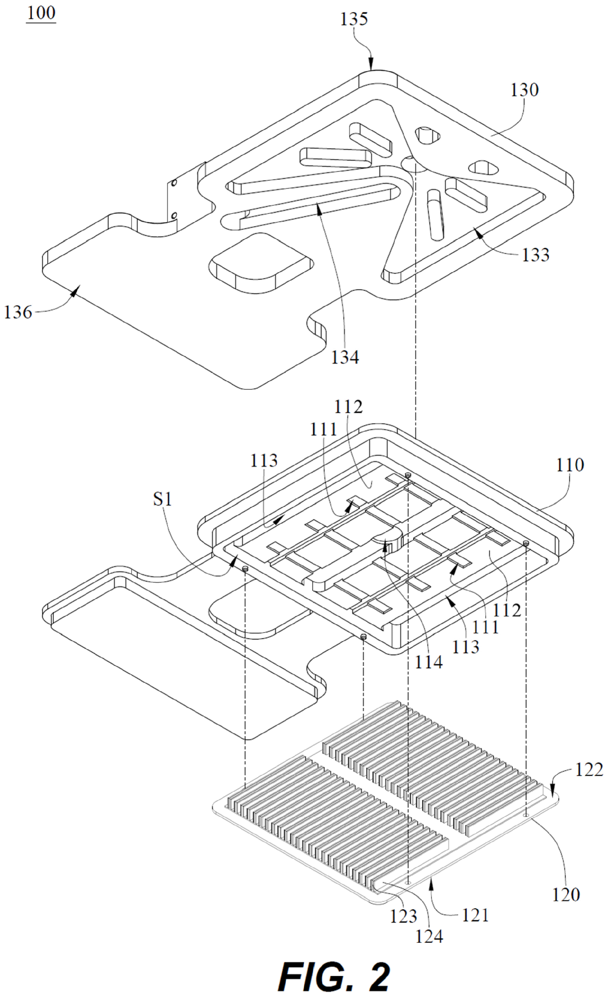

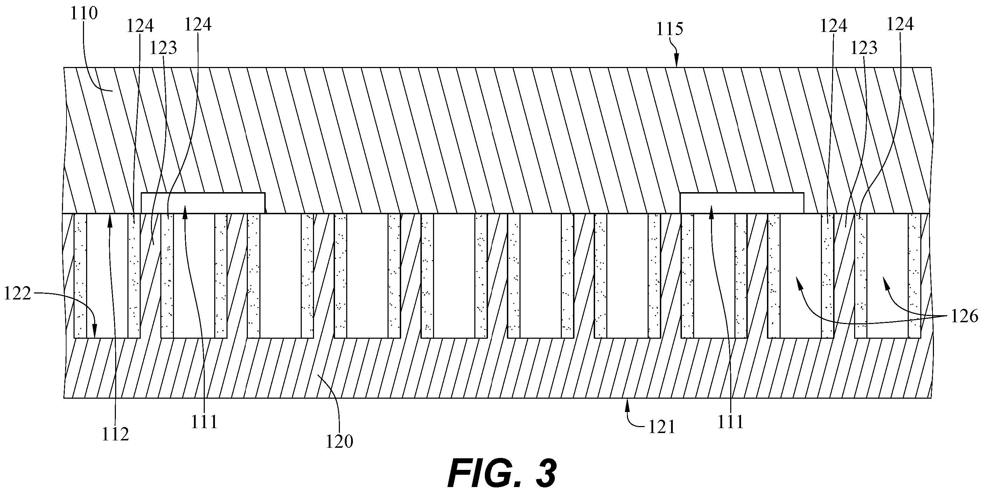

Referring to FIGS. 1-3. FIG. 1 illustrates a perspective view of a liquid cooling heat dissipation device 100 according to aspects of the present disclosure. FIG. 2 illustrates an exploded view of the liquid cooling heat dissipation device 100 of FIG. 1. FIG. 3 illustrates a cross-sectional view of the liquid cooling heat dissipation device 100 of FIG. 1 taken along line 3-3.

As illustrated in FIGS. 1-3, the liquid cooling heat dissipation device 100 may include a base 110, a cover 120, and a plurality of fins 123. Each of the fins 123 may have a plurality of first capillary structures 124 on opposite side surfaces thereof. The liquid cooling heat dissipation device 100 may be configured to accommodate a cooling fluid and may be coupled to an electronic device, for example, by an assembling component. In some embodiments, the cooling fluid may be a fluid that undergoes two-phase change within an operating temperature range, such as, but not limited to, water or a refrigerant. For example, the refrigerant may include R-407C, R-410A, R-134a, or the like.

In some implementations, the base 110 may have a chamber S1 configured to accommodate the cooling fluid for heat exchange. The chamber S1 may include a chamber bottom surface 112. The base 110 may further include at least one first flow channel opening 113 and at least one second flow channel opening 114 located at the chamber bottom surface 112 and extending through the base 110.

In one non-limiting example, two first flow channel openings 113 may be provided at two sides of the base 110 and one second flow channel opening 114 may be provided. The first flow channel openings 113 may be elongated openings and the second flow channel opening 114 may be a circular opening. The second flow channel opening 114 may be located between the two first flow channel openings 113. At least one recessed structure 111 may be formed on the chamber bottom surface 112 of the base 110. In certain examples, a plurality of recessed structures 111 may be provided. In other examples, only one recessed structure may be provided.

In some embodiments, the cover 120 includes a first side surface 121 and a second side surface 122 opposite to each other. The first side surface 121 can be thermally coupled to a heat source. As used herein, "thermally coupled" refers to direct thermal contact or heat transfer through another thermally conductive body. The second side surface 122 of the cover 120 faces the chamber S1. The cover 120 is joined to the base 110 and covers the chamber S1. The chamber bottom surface 112 of the base 110 faces the second side surface 122 of the cover 120.

In some implementations, the fins 123 may be sheet-like structures. For example, the fins 123 may be arranged in two side-by-side rows. The fins 123 extend from the second side surface 122 of the cover 120 and are located in the chamber S1. The first capillary structures 124 may be sintered on opposite side surfaces of each of the fins 123. In some embodiments, the fins 123 and the cover 120 may be integrally formed as a single structure.

In some embodiments, the first capillary structures 124 may be, but are not limited to, three-dimensional printed sintered structures, powder sintered structures, or ceramic sintered structures. The powder sintered structures may be formed of metal powder, such as iron powder, stainless steel powder, bronze powder, brass powder, or the combinations thereof. The first capillary structures 124 can increase heat dissipation surface areas of the fins 123, thereby achieving improved heat dissipation performance within a liquid cooling heat dissipation device of the same size.

In some implementations, the first capillary structures 124 may generate capillary force through microporous structures thereof. In a two-phase-flow cooling application, the capillary force may facilitate separation of liquid-phase cooling fluid from vapor generated by heat absorption and may draw the liquid-phase cooling fluid toward surfaces of the fins 123. As a result, the cooling fluid may be maintained at regions where heat dissipation is desired, thereby improving phase-change heat dissipation efficiency.

In some implementations, heights of the first capillary structures 124 may be equal to heights of the fins 123. The height refers to a distance measured from the second side surface 122 in a direction perpendicular to the second side surface 122. For example, each of the first capillary structures 124 may extend from one end of a corresponding fin 123 to another end of the corresponding fin 123. In certain examples, the first capillary structures 124 may be flush with opposite ends of the fins 123.

In some embodiments, the at least one recessed structure 111 may be formed in a portion of the chamber bottom surface 112 corresponding to at least one of the fins 123. As illustrated in FIG. 3, the recessed structure 111 may provide clearance between the chamber bottom surface 112 and the corresponding fin 123, while other fins 123 may contact the chamber bottom surface 112. In some implementations where heights of the first capillary structures 124 are equal to heights of the fins 123, the recessed structure 111 may provide clearance between the chamber bottom surface 112 and corresponding first capillary structures 124.

In certain implementations, the at least one recessed structure 111 formed on the chamber bottom surface 112 of the chamber S1 of the base 110 may not contact the first capillary structures 124. For example, the at least one recessed structure 111 may be free of the first capillary structures 124 sintered thereon. Space created by the at least one recessed structure 111 may accommodate gas generated by thermal evaporation in a two-phase flow application, thereby achieving more efficient gas-liquid separation and phase-change heat dissipation.

The liquid cooling heat dissipation device 100 may further include a flow channel plate 130. The flow channel plate 130 may have a first flow channel connector opening 131, a second flow channel connector opening 132, at least one first groove channel 133, and at least one second groove channel 134. The first flow channel connector opening 131 and the second flow channel connector opening 132 may be located at a first side 135 of the flow channel plate 130 opposite to the chamber S1. The at least one first groove channel 133 and the at least one second groove channel 134 may be located at a second side 136 of the flow channel plate 130 facing the chamber S1. The flow channel plate 130 may be coupled to a side 115 of the base 110 opposite to the cover 120 by a bonding process, such as brazing.

In some embodiments, the at least one first groove channel 133 and the at least one second groove channel 134 may be fluidly connected to the chamber S1 through the at least one first flow channel opening 113 and the at least one second flow channel opening 114. Through this arrangement, the cooling fluid may flow into or out of the chamber S1.

In one non-limiting example, the cooling fluid may enter the first groove channel 133 of the flow channel plate 130 through the first flow channel connector opening 131. The first groove channel 133 may be fluidly connected to the chamber S1 through the first flow channel openings 113, such that the cooling fluid may flow from the first groove channel 133 into the chamber S1. In the chamber S1, the cooling fluid may flow through the flow channels 126 between adjacent fins 123 and exchange heat with the cover 120. For example, the cooling fluid may absorb thermal energy transferred from the heat source through the first side surface 121 and the second side surface 122 of the cover 120. After heat exchange, the cooling fluid may flow out of the chamber S1 through the second flow channel opening 114, pass through the second groove channel 134, and exit the liquid cooling heat dissipation device 100 through the second flow channel connector opening 132.

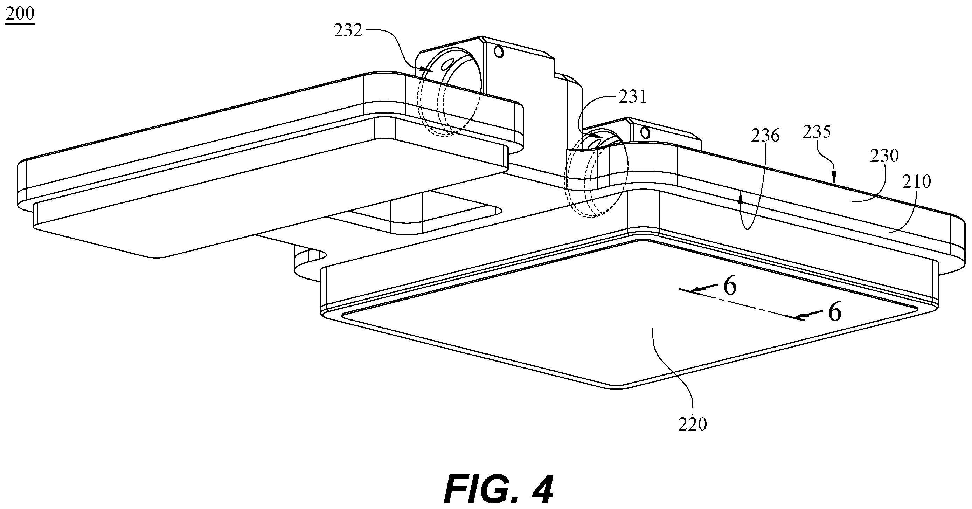

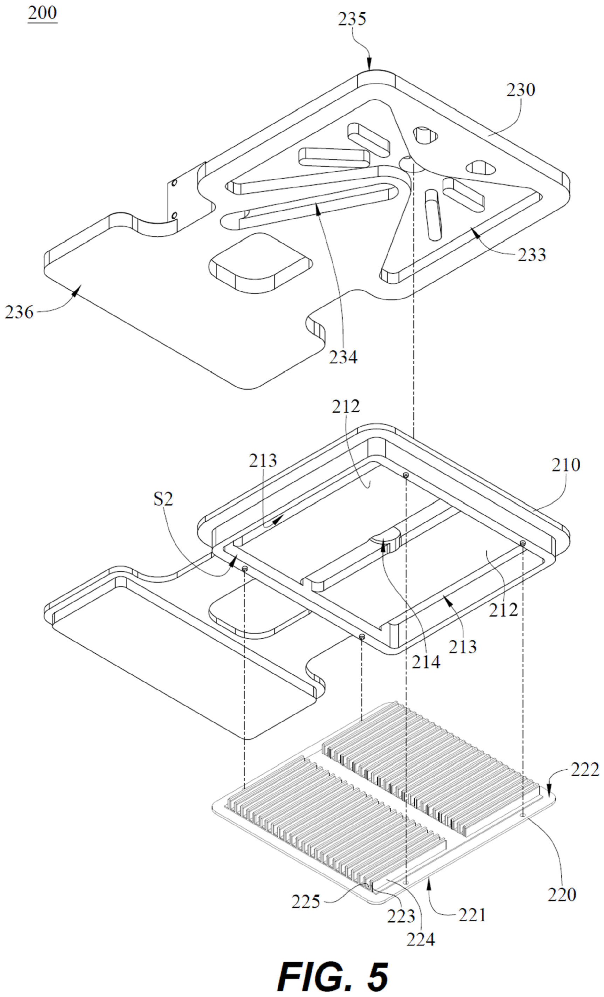

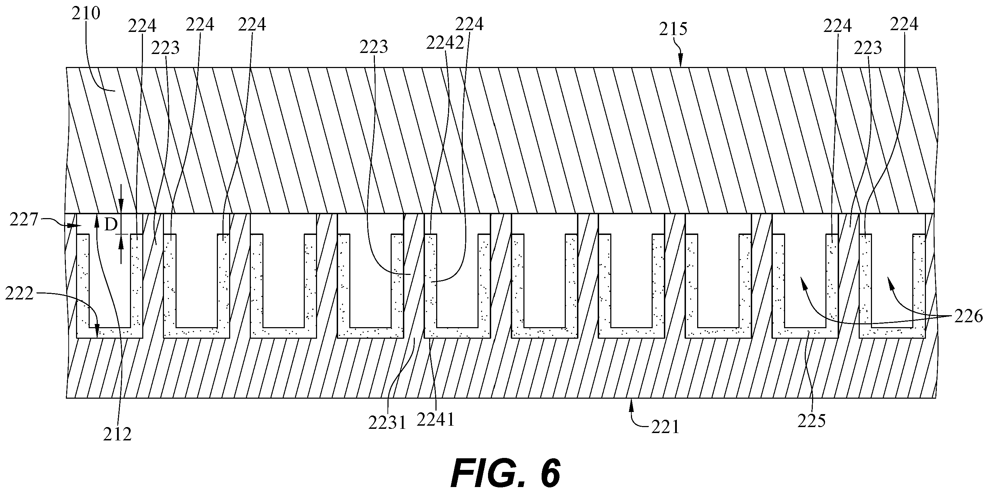

Referring to FIGS. 4-6, FIG. 4 illustrates a perspective view of a liquid cooling heat dissipation device according to aspects of the present disclosure. FIG. 5 illustrates an exploded view of the liquid cooling heat dissipation device of FIG. 4. FIG. 6 illustrates a cross-sectional view of the liquid cooling heat dissipation device of FIG. 4 taken along line 6-6.

As illustrated in FIGS. 4-6, the liquid cooling heat dissipation device 200 may be similar in certain respects to the liquid cooling heat dissipation device 100 illustrated in FIGS. 1-3. For example, the liquid cooling heat dissipation device 200 may include a base 210, a chamber S2, a chamber bottom surface 212, at least one first flow channel opening 213, at least one second flow channel opening 214, a cover 220, a first side surface 221 of the cover 220, a second side surface 222 of the cover 220, a plurality of fins 223, first capillary structures 224, flow channels 226, a flow channel plate 230, a first flow channel connector opening 231, a second flow channel connector opening 232, at least one first groove channel 233, and at least one second groove channel 234. The flow channel plate 230 may include a first side 235 and a second side 236. Unless otherwise described below, features of the liquid cooling heat dissipation device 200 may be the same as or similar to corresponding features of the liquid cooling heat dissipation device 100.

The following discussion focuses primarily on certain differences between the illustrated liquid cooling heat dissipation device 200 and the illustrated liquid cooling heat dissipation device 100. In some implementations, the base 210 may have the chamber bottom surface 212 facing the second side surface 222 of the cover 220. The chamber bottom surface 212 may be free of recessed structures. In certain examples, each of the fins 223 may contact the chamber bottom surface 212.

In some implementations, the first capillary structures 224 may have heights less than the heights of the fins 223. Accordingly, each of the first capillary structures 224 may be spaced apart from the chamber bottom surface 212. For example, each first capillary structure 224 may have a first end 2241 and a second end 2242 opposite to the first end 2241. The first end 2241 may be flush with an end 2231 of a corresponding fin 223 that contacts the second side surface 222. The second end 2242 may stop at a position spaced apart from the chamber bottom surface 212 by a distance D.

In some implementations, because each first capillary structure 224 is spaced apart from the chamber bottom surface 212 by the distance D, a section 227 of each fin 223 may be free of the first capillary structure 224. A larger space may be formed between the sections 227 of adjacent fins 223. In a two-phase-flow cooling application, the larger space may be used to accommodate vapor generated by heat absorption, thereby improving gas-liquid separation. The first capillary structures 224 may draw liquid-phase cooling fluid toward surfaces of the fins 223 where heat dissipation is desired, thereby improving phase-change heat dissipation efficiency. In addition, because the sections 227 are free of the first capillary structures 224, the first capillary structures 224 may be prevented from absorbing brazing filler during a brazing process of the liquid cooling heat dissipation device 200. As a result, failure of the first capillary structures 224 may be reduced or prevented, and manufacturing yield may be improved.

In some embodiments, the liquid cooling heat dissipation device 200 may further include a plurality of second capillary structures 225. The second capillary structures 225 may cover the second side surface 222 of the cover 220. For example, the second capillary structures 225 may extend along the second side surface 222 of the cover 220 and may be perpendicular to the first capillary structures 224.

In some implementations, the first capillary structures 224 and the second capillary structures 225 may be, but are not limited to, three-dimensional printed sintered structures, powder sintered structures, or ceramic sintered structures. The powder sintered structures may be formed of metal powder, such as iron powder, stainless steel powder, bronze powder, brass powder, or combinations thereof. The first capillary structures 224 can increase heat dissipation surface areas of the fins 223. The second capillary structures 225 can increase a heat dissipation surface area of the liquid cooling heat dissipation device 200. Accordingly, improved heat dissipation performance may be achieved within a liquid cooling heat dissipation device of the same size. In some embodiments, the first capillary structures 224 and the second capillary structures 225 are integrally form as a single structure.

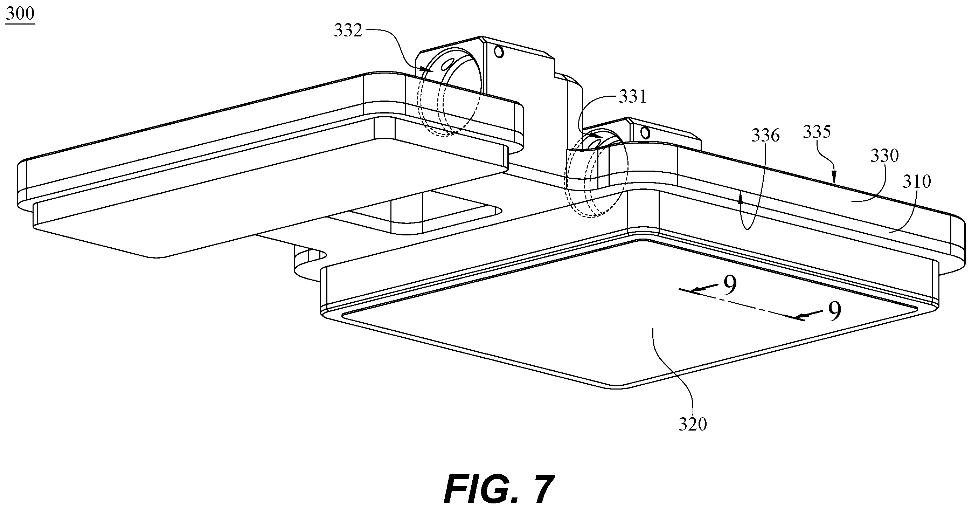

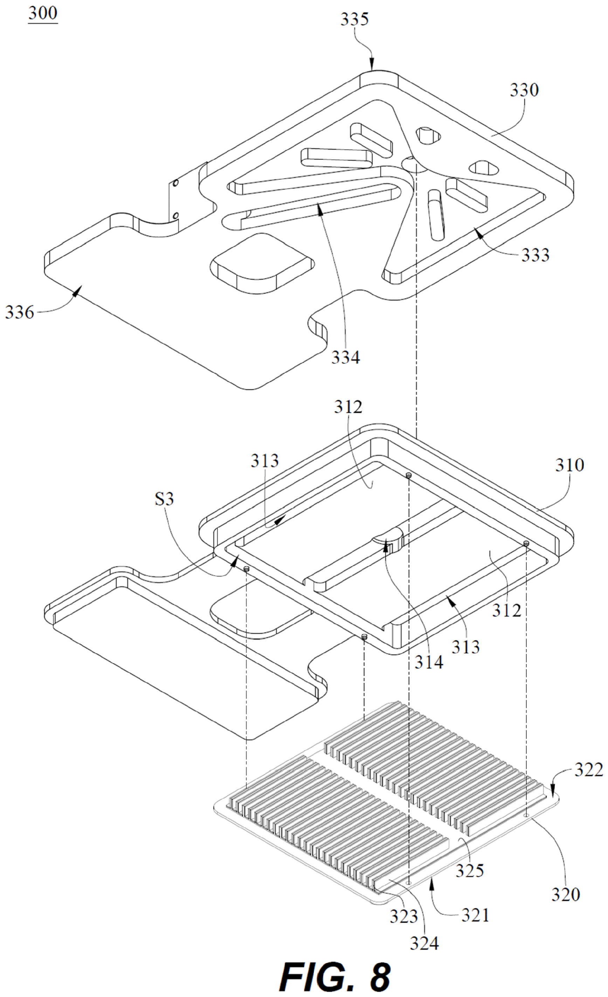

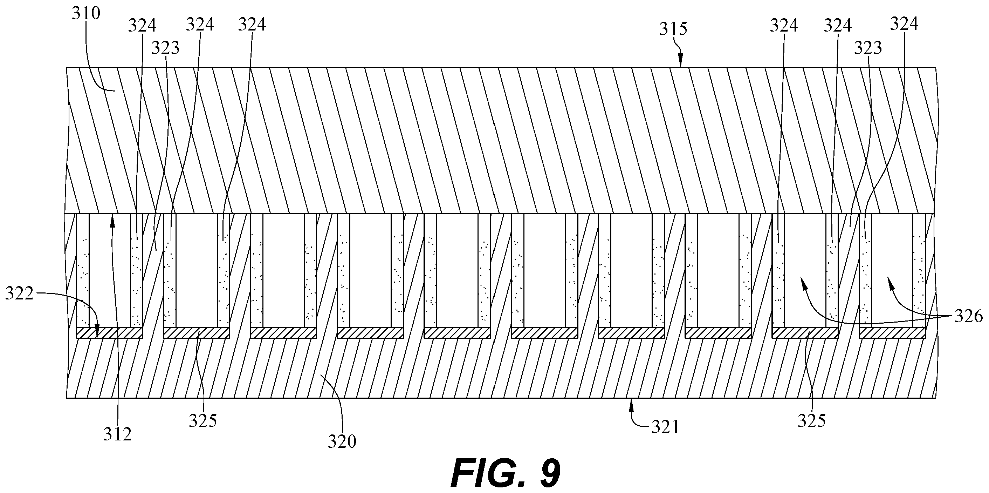

Referring to FIGS. 7-9, FIG. 7 illustrates a perspective view of a liquid cooling heat dissipation device 300 according to aspects of the present disclosure. FIG. 8 illustrates an exploded view of the liquid cooling heat dissipation device 300 of FIG. 7. FIG. 9 illustrates a cross-sectional view of the liquid cooling heat dissipation device 300 of FIG. 7 taken along line 9-9.

As illustrated in FIGS. 7-9, the liquid cooling heat dissipation device 300 may be similar in certain respects to the liquid cooling heat dissipation device 100 illustrated in FIGS. 1-3. For example, the liquid cooling heat dissipation device 300 may include a base 310, a chamber S3, a chamber bottom surface 312, at least one first flow channel opening 313, at least one second flow channel opening 314, a cover 320, a first side surface 321 of the cover 320, a second side surface 322 of the cover 320, a plurality of fins 323, first capillary structures 324, flow channels 326, a flow channel plate 330, a first flow channel connector opening 331, a second flow channel connector opening 332, at least one first groove channel 333, and at least one second groove channel 334. The flow channel plate 330 may include a first side 335 and a second side 336. Unless otherwise described below, features of the liquid cooling heat dissipation device 300 may be the same as or similar to corresponding features of the liquid cooling heat dissipation device 100.

The following discussion focuses primarily on certain differences between the illustrated liquid cooling heat dissipation device 300 and the illustrated liquid cooling heat dissipation device 100. In some implementations, the base 310 may have the chamber bottom surface 312 facing the second side surface 322 of the cover 320. The chamber bottom surface 312 may be free of recessed structures. In certain examples, each of the fins 323 may contact the chamber bottom surface 312. For example, an end of each fin 323 away from the second side surface 322 of the cover 320 may directly abut against the chamber bottom surface 312 of the base 310. In some implementations, an end of each first capillary structure 324 away from the second side surface 322 of the cover 320 may directly abut against the chamber bottom surface 312 of the base 310.

In some embodiments, the liquid cooling heat dissipation device 300 may further include a plurality of second capillary structures 325. The second capillary structures 325 may cover the second side surface 322 of the cover 320. For example, the second capillary structures 325 may extend along the second side surface 322 of the cover 320 and may be perpendicular to the first capillary structures 324.

In some implementations, the first capillary structures 324 and the second capillary structures 325 may be different sintered structures. For example, the first capillary structures 324 may be, but are not limited to, three-dimensional printed sintered structures, powder sintered structures, or ceramic sintered structures. The powder sintered structures may be formed of metal powder, such as iron powder, stainless steel powder, bronze powder, brass powder, or combinations thereof. The second capillary structures 325 may be copper-mesh sintered structures. The copper-mesh sintered structures of the second capillary structures 325 can increase the heat dissipation surface area of the liquid cooling heat dissipation device 300 and enhance the capillary effect. Accordingly, improved heat dissipation performance may be achieved within a liquid cooling heat dissipation device of the same size.

Although the present disclosure has been described with reference to the foregoing illustrated implementations, the illustrated implementations are not intended to limit the present disclosure. A person skilled in the art may make various modifications and changes without departing from the spirit and scope of the present disclosure. Therefore, the scope of patent protection of the present disclosure shall be defined by the appended claims.

## Claims

1. A liquid cooling heat dissipation device (100 200 300) comprising:
a base (110 210 310) defining a chamber (S1 S2 S3) and including at least one first flow channel opening (113 213 313) and at least one second flow channel opening (114 214 314) fluidly connected to the chamber (S1 S2 S3);
a cover (120 220 320) coupled to the base (110 210 310) and enclosing the chamber (S1 S2 S3) at least in part, the cover (120 220 320) including a first side surface (121 221 321) and a second side surface (122 222 322) opposite to the first side surface (121 221 321), the first side surface (121 221 321) being configured to be thermally coupled to a heat source, and the second side surface (122 222 322) facing the chamber (S1 S2 S3);
a plurality of fins (123 223 323) extending from the second side surface (122 222 322) of the cover (120 220 320) into the chamber (S1 S2 S3), each of the fins (123 223 323) including opposite side surfaces and a plurality of first capillary structures (124 224 324) disposed on the opposite side surfaces; and
a flow channel plate (130 230 330) coupled to a side of the base (115 210 310) opposite to the cover (120 220 320), the flow channel plate (130 230 330) including a first flow channel connector opening (131 231 331), a second flow channel connector opening (132 232 332), at least one first groove channel (133 233 333) fluidly connected to the chamber (S1 S2 S3) through the at least one first flow channel opening (113 213 313), and at least one second groove channel (134 234 334) fluidly connected to the chamber (S1 S2 S3) through the at least one second flow channel opening (114 214 314).

2. The liquid cooling heat dissipation device (100 200 300) of claim 1, wherein the at least one first flow channel opening (113 213 313) includes two first flow channel openings (113 213 313) disposed at two opposite sides of the base (110 210 310), and wherein the at least one second flow channel opening (114 214 314) is disposed between the two first flow channel openings (113 213 313).

3. The liquid cooling heat dissipation device (100 200 300) of claim 2, wherein the two first flow channel openings (113 213 313) are elongated openings, and the at least one second flow channel opening (114 214 314) is a circular opening.

4. The liquid cooling heat dissipation device (100 200 300) of one of claims 1 to 3, wherein the flow channel plate (130 230 330) includes a first side (135 235 335) facing away from the chamber (S1 S2 S3) and a second side (136 236 336) facing the chamber (S1 S2 S3), the first flow channel connector opening (131 231 331) and the second flow channel connector opening (132 232 332) are disposed at the first side (135 235 335), and the at least one first groove channel (133 233 333) and the at least one second groove channel (134 234 334) are disposed at the second side (136 236 336).

5. The liquid cooling heat dissipation device (100 200 300) of one of claims 1 to 4, wherein the first capillary structures (124 224 324) include microporous structures configured to generate capillary force.

6. The liquid cooling heat dissipation device (100 200 300) of one of claims 1 to 5, wherein the first capillary structures (124 224 324) include three-dimensional printed sintered structures, powder sintered structures, ceramic sintered structures, or combinations thereof.

7. The liquid cooling heat dissipation device (100 200 300) of claim 6, wherein the powder sintered structures are formed of metal powder including iron powder, stainless steel powder, bronze powder, brass powder, or combinations thereof.

8. The liquid cooling heat dissipation device (100) of one of claims 1 to 7, wherein a height of the first capillary structures (124) is equal to a height of the fins (123).

9. The liquid cooling heat dissipation device (100) of one of claims 1 to 7, wherein the chamber (S1) includes a chamber bottom surface (112) facing the second side surface (122) of the cover (120), and at least one recessed structure (111) is formed in a portion of the chamber bottom surface (112) corresponding to at least one of the fins (123).

10. The liquid cooling heat dissipation device (100) of claim 9, wherein the at least one of the fins (123) corresponding to the at least one recessed structure (111) is spaced apart from the chamber bottom surface (112).

11. The liquid cooling heat dissipation device (100) of claim 9 or 10, wherein at least one of the first capillary structures (124) disposed on the at least one of the fins (123) corresponding to the at least one recessed structure (111) is spaced apart from the chamber bottom surface (112).

12. The liquid cooling heat dissipation device (200) of one of claims 1 to 7, wherein the chamber (S2) includes a chamber bottom surface (212) facing the second side surface (222) of the cover (220), and wherein a height of the first capillary structures (224) are less than a height of the fins (223) such that each of the first capillary structures (224) is spaced apart from the chamber bottom surface (212).

13. The liquid cooling heat dissipation device (200) of claim 12, wherein each of the first capillary structures (224) includes a first end (2241) and a second end (2242) opposite to the first end (2241), the first end (2241) is flush with an end (2231) of a corresponding fin (223) that contacts the second side surface, and wherein the second end (2242) is spaced apart from the chamber bottom surface (212).

14. The liquid cooling heat dissipation device (200) of claim 12 or 13, wherein each of the fins (223) includes an exposed section (227) between the second end (2242) of a corresponding first capillary structure (224) and the chamber bottom surface (212).

15. The liquid cooling heat dissipation device (200) of one of claims 12 to 14, further comprising a plurality of second capillary structures (225) disposed on the second side surface (222) of the cover (220).

16. The liquid cooling heat dissipation device (200) of claim 15, wherein the second capillary structures (225) extend along the second side surface (222) of the cover (220) and are perpendicular to the first capillary structures (224).

17. The liquid cooling heat dissipation device (200) of claim 15 or 16, wherein the second capillary structures (225 325) comprise three-dimensional printed sintered structures, powder sintered structures, ceramic sintered structures, or combinations thereof.

18. The liquid cooling heat dissipation device (300) of one of claims 1 to 7, further comprising a plurality of second capillary structures (325) disposed on the second side surface (322) of the cover (320), wherein the chamber (S2 S3) includes a chamber bottom surface (112 212 312) facing the second side surface (322) of the cover (320), and wherein ends of the fins (323) away from the second side surface (322) directly abut against the chamber bottom surface (312).

19. The liquid cooling heat dissipation device (300) of claim 18, wherein ends of the first capillary structures (324) away from the second side surface (322) directly abut against the chamber bottom surface (312).

20. The liquid cooling heat dissipation device (300) of claim 18 or 19, wherein the first capillary structures (324) comprise three-dimensional printed sintered structures, powder sintered structures, ceramic sintered structures, or combinations thereof, and the second capillary structures (325) are copper-mesh sintered structures.
